Europäisches Patentamt

European Patent Office

Office européen des brevets

(11) Publication number: **0 107 902**
**B1**

(12) **EUROPEAN PATENT SPECIFICATION**

(45) Date of publication of patent specification: **19.04.89**

(51) Int. Cl.⁴: **H 01 L 21/76**

(21) Application number: **83305442.2**

(22) Date of filing: **16.09.83**

(54) A method for fabricating isolation regions in semiconductor devices.

(30) Priority: **29.09.82 JP 171977/82**

(43) Date of publication of application:
**09.05.84 Bulletin 84/19**

(45) Publication of the grant of the patent:
**19.04.89 Bulletin 89/16**

(84) Designated Contracting States:
**DE FR GB**

(73) Proprietor: **FUJITSU LIMITED**
**1015, Kamikodanaka Nakahara-ku**
**Kawasaki-shi Kanagawa 211 (JP)**

(72) Inventor: **Goto, Hiroshi c/o FUJITSU LIMITED**
**Patent Department 1015 Kamikodanaka**
**Nakahara-ku Kawasaki 211 (JP)**
Inventor: **Tabata, Akira c/o FUJITSU LIMITED**
**Patent Department 1015 Kamikodanaka**
**Nakahara-ku Kawasaki 211 (JP)**

(74) Representative: **Sunderland, James Harry et al**
**HASELTINE LAKE & CO Hazlitt House 28**
**Southampton Buildings Chancery Lane**
**London WC2A 1AT (GB)**

(56) References cited:
EP-A-0 020 994
EP-A-0 097 789
US-A-3 411 051
US-A-4 255 207
JAPANESE JOURNAL OF APPLIED PHYSICS
SUPPLEMENT, vol. 21, no. 1, 1982, pages
37-40; Y. TAMAKI et al.: "U-groove isolation
technology for high density bipolar LSI's"
IBM TECHNICAL DISCLOSURE BULLETIN, vol.
23, no. 11, April 1981, pages 4917-4919, New
York, US; I. ANTIPOV: "Prevention of birdsbeak
formation"

(56) References cited:
IBM TECHNICAL DISCLOSURE BULLETIN, vol.
24, no. 9, February 1982, pages 4738-4739, New
York, US; I. ANTIPOV: "Polysilicon trench
isolation"
J.E.E. JOURNAL OF ELECTRONIC
ENGINEERING, vol. 19, no. 188, August 1982,
pages 36-39, Tokyo, JP; A. HAYASAKA et al.:
"U-groove isolation technology"

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

The present invention relates to a method for fabricating regions to isolate devices in a semiconductor substrate.

In an integrated circuit (IC), many devices are composed in the same semiconductor substrate. It is necessary to isolate these devices from each other, so isolation regions are fabricated between the devices. Formerly, isolation using p-n junctions was common. But the capacitance inherent in the p-n junction decreased the speed of circuit performance. Hence dielectric isolation is becoming widely used due to its merits of low parasitic capacitance and high circuit performance.

Among dielectric isolation technologies, isolation with oxide and polycrystal silicon (IOP) is commonly used for bipolar ICs. This involves fabricating isolation grooves by etching between the devices, and filling these grooves with a silicon dioxide ($SiO_2$) layer and polycrystal silicon (polysilicon).

In early IOP technology, a wet etching process was employed and the result was a V-shaped cross section of the isolation groove. The V-shape is due to different etching speeds in different directions relative to the substrate crystal axis. Recently, however, it has become possible to make a groove having a U shaped cross section, by applying a dry etching technology.

This U-shaped groove is preferable to a V-shaped groove, because the width of the groove can be made narrower, for the same groove depth. This allows higher packing density of devices on an IC die. Recently, therefore, U-shaped isolation grooves have been used widely.

However, even in the case of device isolation by a U-shaped groove, there are some defects which limit the packing density. These defects will be explained by reference to an example of a previously proposed process for forming U-shaped groove isolation regions.

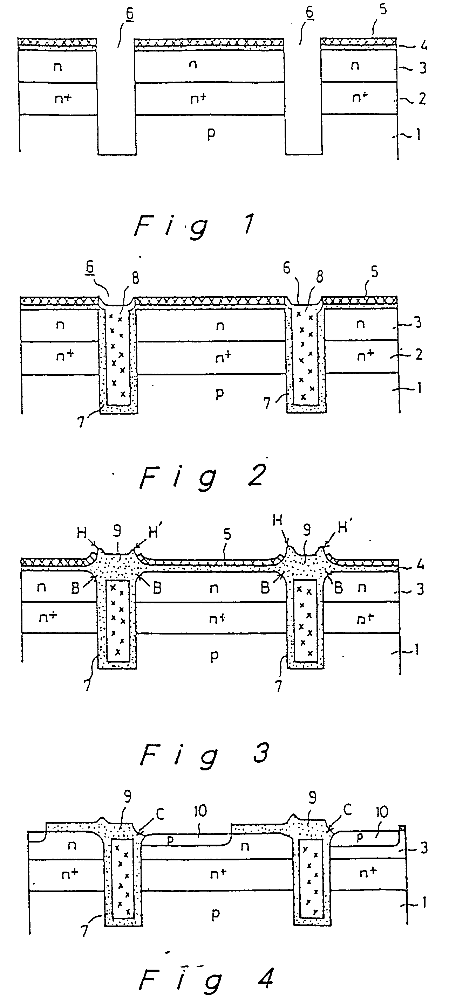

Figures 1, 2, 3 and 4 are schematic cross sectional views illustrating a previously proposed process for fabricating a U-shaped isolation region in semi-conductor substrate. In Figure 1, 1 is a silicon substrate made of p-type silicon, and 2 and 3 are $n^+$ and n-type silicon single crystal layers formed by diffusion and epitaxial growth technology, on the substrate.

On the surface of the n-type silicon 3, films of silicon dioxide ($SiO_2$) 4 and silicon nitride ($Si_3N_4$) 5 are formed successively. The $SiO_2$ film 4 protects the silicon layer 3 from flaws. Photo-lithographical etching is used to open holes on the silicon nitride film 5. Then, using the remaining film 5 of silicon nitride as a mask, U-shaped grooves 6 are made by dry etching. Reactive ion etching is the preferable method for making a sharp U-shape groove, as will be described hereinafter. The remaining parts of the $n^+$ and n-layers of silicon 2 and 3 are isolated by the grooves 6. The $n^+$-layer 2 later becomes a buried layer for bipolar elements, and the n-layer 3 becomes a zone in which bases and emitters are fabricated.

Next, the surface of the substrate is oxidised, and the inner surface of each U-shaped groove 6 becomes coated by a thin layer of $SiO_2$ 7 as shown in Figure 2. Then on the surface of the substrate is grown a layer of polysilicon (not shown), which completely buries the grooves 6. The polysilicon grown on the surface of the substrate (not shown) is removed by polishing or etching, leaving the buried polysilicon 8 as shown in Figure 2. In this etching process, the buried polysilicon 8 in the grooves 6 is slightly over etched leaving a depression as shown in the Figure.

The substrate is then subjected to a high temperature of 1000 to 1100°C for a few hours. This oxidises the upper part of the polysilicon 8 to form a $SiO_2$ layer 9 of about 1 μm thickness. During this oxidation the volume of polysilicon approximately doubles and so a projection forms as shown in Figure 3.

The reason for making such a thick oxide layer 9 on the upper part of the U-shaped isolation groove 6 is to realise a so called "walled base" and "walled emitter".

The thick oxide layer limits the side length of base and emitter by this isolation region, and provides the base and emitter by self-alignment. The walled base and walled emitter will be described hereinafter. Another reason for providing the thick oxide layer is to decrease the stray capacitance of the wiring layer formed later on the surface of this oxide layer.

In Figure 4 a possible configuration of a walled base is shown schematically. The film of silicon nitride 5 in Figure 3 is removed using boiled phosphoric acid ($H_3PO_4$), and silicon dioxide 4 is removed by photo-lithographical etching, exposing the base area 10. In this example the left hand side of base 10 in the Figure is limited by the isolation region, so the alignment of the mask for the base opening is not critical, as it may extend to the isolation region without any ill effects. This is called "self alignment". In the example of Figure 4, the mask extends to a point shown H' in Figure 3, but the thickness of the oxide layer 9 is sufficient to prevent exposure during etching of the buried polysilicon 8 at point C in Figure 4. An emitter can be also self-aligned in the same manner on the left hand side of base 10. It is not shown in the Figure for the sake of simplicity.

Growing such a thick oxide layer 9, however, produces a "bird's beak" B and "bird's head" H as shown in Figure 3. The bird's beak B is a $SiO_2$ film part encroaching under the silicon nitride film 5, and the bird's head H is a $SiO_2$ film grown around the groove and raised by the oxidation of silicon at the side wall of the groove. The thicker the oxide layer 9 is grown, the larger they grow.

The bird's head may reach a height of up to 0.8 μm, and the bird's beak may spread to a 1.5 μm. The bird's head increases the unevenness of the substrate surface, making it difficult to provide multi-layered wiring on the surface. The bird's beak spreads laterally on the surface of substrate, and decreases the packing density of devices, increasing the width of isolation region required between devices. The benefit of a sharp narrow U-shaped isolation groove is hence reduced.

US—A—3 411 051 discloses semiconductor substrate with a U-shaped isolation groove, the inner surface of which is covered with an insulating layer and which is filled with polycrystalline material. Oxide film is formed over the polycrystalline material.

US—A—4 255 207 relates to V-groove isolation in which the groove is filed with polycrystalline material which is then etched back to recess its top surface, before the polycrystalline material is thermally oxidised.

According to the present invention there is provided a method of fabricating an isolation region in a semiconductor substrate, including:—

(a) forming a U-shaped isolation groove in the substrate;

(b) covering the inner surface of the groove with an insulating layer;

(c) filling the groove to a selected level, below the substrate surface, with polycrystal semiconductor material;

(d) forming insulating material on the polycrystal semiconductor material, by a deposition process, to fill the remainder of the groove.

An embodiment of the present invention can provide a method for fabricating an isolation region which has neither a bird's beak nor a bird's head. It can provide a flat substrate surface preferable for multilayered wiring, and contribute towards increased packing density of devices in bipolar IC circuits.

In a method embodying the present invention an isolation groove is made by reactive ion etching, and its inner surface is coated by an insulation film. The groove is then buried by polycrystal semiconductor material. The polycrystal semiconductor material which is deposited on the surface of substrate is etched off and removed from the groove to a specific depth.

An insulation film is then grown so as to fill up the groove.

Then the substrate surface is polished or etched to provide a flat surface.

The selected depth may be in the range 0.2 $\mu$m to 1 $\mu$m.

Reference is made, by way of example, to the accompanying drawings, in which:—

Figures 1 to 4 are respective schematic cross-sectional views illustrating stages in a previously proposed process for making an isolation region in a substrate, and

Figures 5 to 9 are respective schematic cross-sectional views illustrating stages in a process embodying the present invention.

Each Figure from 5 to 9 shows schematically a cross section of a substrate during a process for fabricating isolation regions according to an embodiment of the present invention.

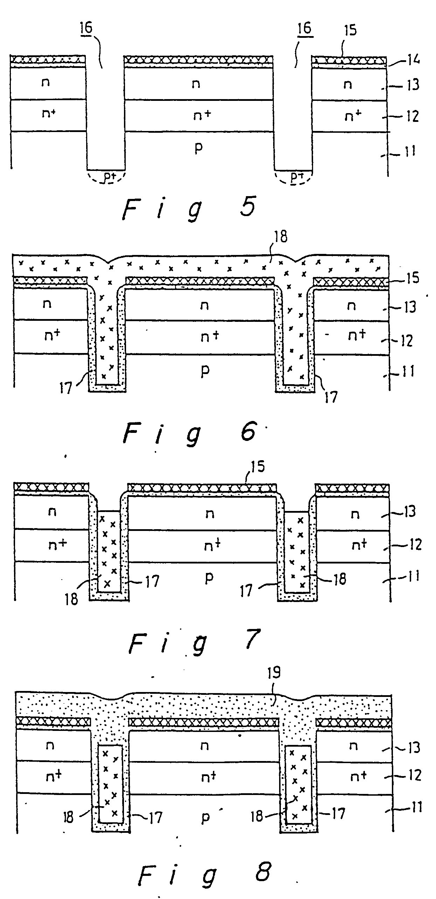

In Figure 5, 11 is a p-type silicon substrate, and 12 and 13 are a $n^+$ layer (that is, a layer highly doped by n type dopant) and a n layer respectively, formed on the substrate 11. These layers usually have a thickness of about 1.5 $\mu$m and are fabricated successively on substrate 11 by diffusion and epitaxial growth technology.

In the following description a p-type silicon substrate is used as an example, but the substrate, and the layers formed on the substrate, may be of any type. The thicknesses of the layers may be also altered, depending on the device design. In the description hereinafter, the word substrate will be used to mean a slice of semiconductor on which some layers are formed to fabricate semiconductor devices.

The surface of the substrate is coated by a silicon dioxide ($SiO_2$) film 14 of 100 nm (1000 Å) thick. A further film of silicon nitride ($Si_3N_4$) 15 of about 200 nm (2000 Å) thickness is then coated on film 14. These films are fabricated using ordinary technology such as thermal oxidation and chemical vapor deposition (CVD).

A window 16 for the isolation region is then opened on the $Si_3N_4$ film 15 by photolithographical etching. Leaving the remaining part of the $Si_3N_4$ film as a mask, a U-shaped groove 16 4 to 5 $\mu$m deep and 2 to 3 $\mu$m wide is made by dry etching. The type of dry etching used in this process is reactive dry etching using a mixture of carbon tetrachloride ($CCl_4$) and boron trichloride ($BCl_3$). By this process (the details of which are disclosed in U.S. Pat. No. 4,104,086 issued Aug. 1, 1979 to J. A. Bondur and H. G. Pogge) the side walls of the groove 16 are etched vertically to shape a U-groove. The bottom of the groove reaches to p type substrate 11, cutting through both the layers 12 and 13.

As shown in Figure 5, in this embodiment of the invention, boron ions are implanted by ion implantation technology, to form a $p^+$ region (that is, a region which is doped highly by p type dopant) at the bottom of the groove 16. This region is used as a channel stopper. It is omitted from the following description and Figures.

In the next step of the process, as shown in Figure 6, the inner surface of the groove 16 is coated with an $SiO_2$ film 17 whose thickness is about 200 to 300 nm (2000 to 3000 Å), by thermal oxidation. Then, un-doped polysilicon is deposited over the surface of the substrate, filling and burying the groove 16.

The polysilicon 18 deposited on the surface of the $Si_3N_4$ film 15 is removed by wet etching as shown in Figure 7. A common etchant such as caustic potash (KOH) or a mixture of nitric acid ($HNO_3$) and hydrofluoric acid (HF) may be used. In this etching process, the upper part of the polysilicon burying the groove 16 is also removed. The etching at the groove is controlled to a depth of 0.5 to 1 $\mu$m from the surface of the $Si_3N_4$ film 15. The specific depth to which the groove is etched is not so critical but the etching is important to prevent a bird's beak and bird's head from growing.

Next, as shown in Figure 8, $SiO_2$ film 19 is deposited on the surface of the substrate by the bias sputtering method. By this process the groove *16* is buried again, this time by SiO$_2$. Bias sputtering is a good means of depositing SiO$_2$ on the surface of a target which is electrically biased at about a hundred and a few tens of volts. It is an easy method to use and gives good coverage. Bias sputtering is disclosed in JP—A—55—13904 by Tsunekawa et al. However, it may be replaced by an ordinary CVD method.

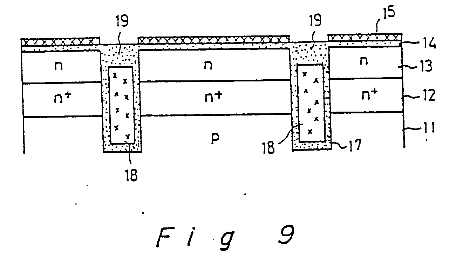

Next, as shown in Figure 9, the SiO$_2$ film deposited on the surface of the Si$_3$N$_4$ film 15 is removed by etching. Wet etching by hydrofluoric acid or dry etching using trifluoro-methane gas are applicable in the case of SiO$_2$ deposited by the bias sputtering method. For SiO$_2$ deposited by the CVD process, chemical polishing is effective for the same purpose. The Si$_3$N$_4$ film is then removed by boiling phosphoric acid (H$_3$PO$_4$).

Comparing Figure 9 with Figure 3, it will be apparent that isolation regions fabricated in accordance with an embodiment of the present invention have neither bird's beaks nor bird's heads. Self aligned walled bases and emitters can be provided. Since the polysilicon 18 is buried deep in SiO$_2$ film 19, there is no possibility of the polysilicon being exposed by etching processes as mentioned above to cause electrical circuit leakage in a finished IC. A smooth surface, as is preferable for multi-layer wiring, is provided. The absence of bird's beaks allows the packing density of devices in an IC to be increased.

As has been described above, an embodiment of the present invention can be provided which does not need any new or special process technology and can be applied to any type of device.

The explanation above has been given with reference to p type silicon substrate. However, embodiments of the present invention can be applied to any kind of semiconductor material to fabricate isolation regions for the device formed in it.

## Claims

1. A method of fabricating an isolation region in a semiconductor substrate, including:—

(a) forming a U-shaped isolation groove (16) in the substrate (11 to 15);

(b) covering the inner surface of the groove (16) with an insulating layer (17);

(c) filling the groove (16) to a selected level, below the substrate surface, with polycrystal semiconductor material (18);

(d) forming insulating material (19) on the polycrystal semiconductor material (18), by a deposition process, to fill the remainder of the groove (16).

2. A method as claimed in claim 1, wherein (c) comprises:—

completely filling the groove (16) with the polycrystal semiconductor material (18), and

etching off the polycrystal semiconductor material (18) down to the selected level below the substrate surface.

3. A method as claimed in claim 2, wherein the polycrystal semiconductor material (18) is etched off by a wet etching process.

4. A method as claimed in claim 1, 2 or 3, wherein the insulating material (19) is formed on the polycrystal semiconductor material (18) by bias sputtering.

5. A method as claimed in claim 1, 2 or 3 wherein the insulating material (19) is formed on the polycrystal semiconductor material (18) by chemical vapor deposition.

6. A method as claimed in any preceding claim, wherein a highly doped region is formed beneath the bottom of the groove (16) to provide a channel stopper.

7. A method as claimed in any preceding claim, wherein the groove (16) is 4 to 5 μm deep and 2 to 3 μm wide, and the selected level is 0.2 μm to 1 μm below the substrate surface.

8. A method as claimed in any preceding claim, wherein the substrate (11, 12, 13) is silicon, the insulating layer (17) and the insulating material (19) are silicon dioxide and the polycrystal semiconductor material (18) is polysilicon.

9. A method as claimed in any preceding claim, further comprising:—

(e) polishing the surface of the substrate (11 to 15) to remove such insulating material (19) from the surface, or

(f) wet etching, using hydrofluoric acid, or dry etching, using tri-fluoro methane gas, the surface of the substrate (11 to 15) to remove such insulating material (19) from the surface of the substrate.

## Patentansprüche

1. Verfahren zur Herstellung eines Isolationsbereichs in einem Halbleitersubstrat, mit:—

(a) Bilden einer U-förmigen Isolationsnut (16) in dem Substrat (11 bis 15);

(b) Bedecken der inneren Oberfläche der Nut (16) mit einer isolierenden Schicht (17);

(c) Füllen der Nut (16) auf einen ausgewählten Pegel, unterhalb der Substratoberfläche, mit polykristallinem Halbleitermaterial (18);

(d) Bilden von isolierendem Material (19) auf dem polykristallinen Halbleitermaterial (18), durch ein Abscheidungsverfahren, um den Rest der Nut (16) zu füllen.

2. Verfahren nach Anspruch 1, bei dem (c) umfaßt:—

das vollständige Füllen der Nut (16) mit polykristallinem Halbleitermaterial (18) und

Wegätzen des polykristallinen Halbleitermaterials (18), hinunter bis zu dem ausgewählten Pegel unterhalb der Substratoberfläche.

3. Verfahren nach Anspruch 2, bei dem das polykristalline Halbleitermaterial (18) durch ein Feuchtätzverfahren weggeätzt wird.

4. Verfahren nach Anspruch 1, 2 oder 3, bei dem das isolierende Material (19) auf dem polykristallinen Halbleitermaterial (18) durch vorgespanntes Zerstäuben gebildet wird.

5. Verfahren nach Anspruch 1, 2 oder 3, bei dem das isolierende Material (19) auf dem polykristallinen Halbleitermaterial (18) durch chemische Dampfabscheidung gebildet wird.

6. Verfahren nach einem der vorhergehenden Ansprüche, bei dem ein hochdotierter Bereich unterhalb des Bodens der Nut (16) gebildet wird, um einen Kanalstopper vorzusehen.

7. Verfahren nach einem der vorhergehenden Ansprüche, bei dem die Nut (16) 4 bis 5 µm tief und 2 bis 3 µm breit ist, und der ausgewählte Pegel 0,2 µm bis 1 µm unterhalb der Substratoberfläche ist.

8. Verfahren nach einem der vorhergehenden Ansprüche, bei dem das Substrat (11, 12, 13) Silicium ist, die isolierende Schicht (17) und das isolierende Material (19) Siliciumdioxid sind, und das polykristalline Halbleitermaterial (18) Polysilicium ist.

9. Verfahren nach einem der vorhergehenden Ansprüche, ferner mit:—

(e) Polieren der Oberfläche des Substrats (11 bis 15), um solch isolierendes Material (19) von der Oberfläche zu entfernen, oder

(f) Feuchtätzen, unter Verwendung von Chlorwasserstoffsäure, oder Trockenätzen, unter Verwendung von tri-Fluor-Methangas, der Oberfläche des Substrats (11 bis 15), um solch isolierendes Material (19) von der Oberfläche des Substrats zu entfernen.

**Revendications**

1. Procédé de fabrication d'une région d'isolation dans un substrat semiconducteur, comprenant les opérations suivantes:

(a) former une rainure d'isolation (16) en forme de U dans le substrat (11 à 15);

(b) recouvrir la surface interne de la rainure (16) à l'aide d'une couche isolante (17);

(c) remplir la rainure (16) jusqu'à un niveau sélectionné, situé au-dessous de la surface du substrat, à l'aide d'un matériau semiconducteur polycrystallin (18);

(d) former un matériau isolant (19) sur le matériau semiconducteur polycristallin (18), par un procédé de dépôt, afin de remplir le reste de la rainure (16).

2. Procédé selon la revendication 1, où l'opération (c) consiste à:

remplir complètement la rainure (16) à l'aide du matériau semiconducteur polycristallin (18), et éliminer par incision le matériau semiconducteur polycristallin (18) jusqu'au niveau sélectionné situé au-dessous de la surface du substrat.

3. Procédé selon la revendication 2, où on élimine par incision le matériau semiconducteur polycristallin (18) à l'aide d'un processus d'incision par voie humide.

4. Procédé selon la revendication 1, 2 ou 3, où un forme le matériau isolant (19) sur le matériau semiconducteur polycrystallin (18) par une pulvérisation sous polarisation électrique.

5. Procédé selon la revendication 1, 2 ou 3, où on forme le matériau isolant (19) sur le matériau semiconducteur polycristallin (18) par un dépôt chimique sous forme vapeur.

6. Procédé selon l'une quelconque des revendications précédentes, où on forme une région fortement dopée au-dessous du fond de la rainure (16) de manière à produire un élément d'arrêt de canal.

7. Procédé selon l'une quelconque des revendications précédentes, où la rainure (16) a une profondeur de 4 à 5 µm et une largeur de 2 à 3 µm, et le niveau sélectionné se situe à une distance de 0,2 à 1 µm au-dessous de la surface du substrat.

8. Procédé selon l'une quelconque des revendications précédentes, où le substrat (11, 12, 13) est fait de silicium, la couche isolante (17) et le matériau isolant (19) sont faits de dioxyde de silicium, et le matériau semiconducteur polycristallin (18) est du silicium polycristallin.

9. Procédé selon l'une quelconque des revendications précédentes, comprenant en outre l'opération suivante:

(e) polir la surface du substrat (11 à 15) de manière à retirer de la surface ce matériau isolant (19), ou bien

(f) inciser par voie humide, à l'aide d'acide fluorhydrique, ou bien inciser à sec, à l'aide de trifluorométhane sous forme gazeuse, la surface du substrat (11, 15) de manière à enlever de la surface du substrat ce matériau isolant (19).

Fig 1

Fig 2

Fig 3

Fig 4

1

F i g 5

F i g 6

F i g 7

F i g 8

2

F i g 9